Europäisches Patentamt

European Patent Office

Office européen des brevets

(19)

(11) Publication number: **0 376 953 B1**

## EUROPEAN PATENT SPECIFICATION

(12)

(45) Date of publication of patent specification: 29.09.93

(51) Int. Cl.⁵: **H03K 3/356**, G05F 3/24, H03F 3/45

(21) Application number: **88905804.6**

(22) Date of filing: **30.06.88**

(86) International application number:
**PCT/EP88/00595**

(87) International publication number:
**WO 90/00326 (11.01.90 90/02)**

Divisional application 92200259.7 filed on 30/06/88.

(54) **ELECTRONIC DEVICES AND SIGNAL COMPARATOR USING SAME.**

(43) Date of publication of application:
**11.07.90 Bulletin 90/28**

(45) Publication of the grant of the patent:
**29.09.93 Bulletin 93/39**

(84) Designated Contracting States:
**BE CH DE IT LI**

(56) References cited:
**US-A- 4 661 779**

**Ieee Journal of Solid-State Circuits, vol.SC-14, no.1, February 1979, IEEE (New York US), KB Ohri et al: "Integrated PCM codec", pages 38-46**

**1986 IEEE International Solid-State Circuits Conference, Digest of Technical Papers, First Edition, February 1986, Lewis Winner (Coral Gables, Florida US), JM Steininger et al: "A 50Mb/s CMOS optical data link receiver integrated circuit", pages 60,61,304**

(73) Proprietor: **BELL TELEPHONE MANUFACTUR-ING COMPANY NAAMLOZE VENNOOTSCHAP Francis Wellesplein 1 B-2018 Antwerpen(BE)**

(84) Designated Contracting States:
**BE**

(73) Proprietor: **ALCATEL N.V. Strawinskylaan 537 (World Trade Center) NL-1077 XX Amsterdam(NL)**

(84) Designated Contracting States:
**CH DE IT LI**

(72) Inventor: **SEVENHANS, Joannes, Mathilde, Josephus Prins Kavellei 26 B-2130 Brasschaat(BE)**

EP 0 376 953 B1

Rank Xerox (UK) Business Services
(3.10/3.6/3.3.1)

Inventor: **GUEBELS, Pierre-Paul, François, Maurice, Marie**
**Ridder Gerardlaan 53**
**B-2520 Edegem(BE)**

(74) Representative: **Vermeersch, Robert et al**
**BELL TELEPHONE MANUFACTURING COM-**
**PANY Naamloze Vennootschap Patent De-**
**partment Francis Wellesplein 1**
**B-2000 Antwerp (BE)**

## Description

The present invention relates to a bistate device including two parallel branches each comprising the series connection of a first transistor of a first conductivity type and a second transistor of a second conductivity type, the current in said first transistor of each branch being controlled from the junction point of the first and second transistors of the opposite branch, and a diode-connected third transistor which is of said first conductivity type being connected between the control electrode of said first transistor and a reference voltage terminal.

Such a bistate device is already known in the art, e.g. from the article "Integrated PCM Codec" by K.B. Ohri et al, published in the IEEE Journal of Solid-State Circuits, Vol. SC-14, No 1, February 1979, pages 38 to 46, and more particularly from Fig. 13 and the accompanying text on pages 44-45. In this known device the second transistors are each connected in series with a common current source so as to form a so-called differential pair, i.e. wherein the sum of the currents in these transistors is always equal to the current provided by the current source. It has a single operation threshold (ground) and is used as a comparator.

An object of the present invention is to provide a bistate device of the above type which not only has two distinct operation hysteresis thresholds, but wherein these thresholds are almost independent from parameters of the process by which the transistors are made.

According to the invention this object is achieved due to the fact that each of said control electrodes of said first transistors is coupled to said junction point through a fourth transistor of said second conductivity type whose control elect rode is connected to said reference voltage terminal, the series connection of a third and a fourth transistor forming a current control device.

The above object is thus achieved since two distinct hysteresis operation thresholds are realized in the above junction points, the threshold in the junction point of one branch being function of the voltage in the junction point of the other branch. Indeed, since each current control device formed by a third and a fourth transistor is connected between a junction point and the corresponding controlled first transistor, a current which is dependent on the latter voltage and flows in the fourth transistor is mirrored by the third transistor into the associated first transistor. The current in this first transistor is independent from the parameters of the process by which the first and third transistors are made and is only dependent on the process parameters of the fourth transistor. But since a threshold in a junction point depends on the currents in the fourth and second transistors and these are both of the same conductivity type the threshold can be made substantially independent of the parameters of the process to make these fourth and second transistors.

The above mentioned and other objects and features of the invention will become more apparent and the invention itself will be best understood by referring to the following description of an embodiment taken in conjunction with the accompanying drawings in which :

Fig. 1 shows a signal comparator including a bistate device ST according to the invention and associated to a current source BS, an input circuit IC and a bistable device FF; and

Figs. 2 to 5 show various signal waveforms appearing at terminals of the signal comparator of Fig. 1.

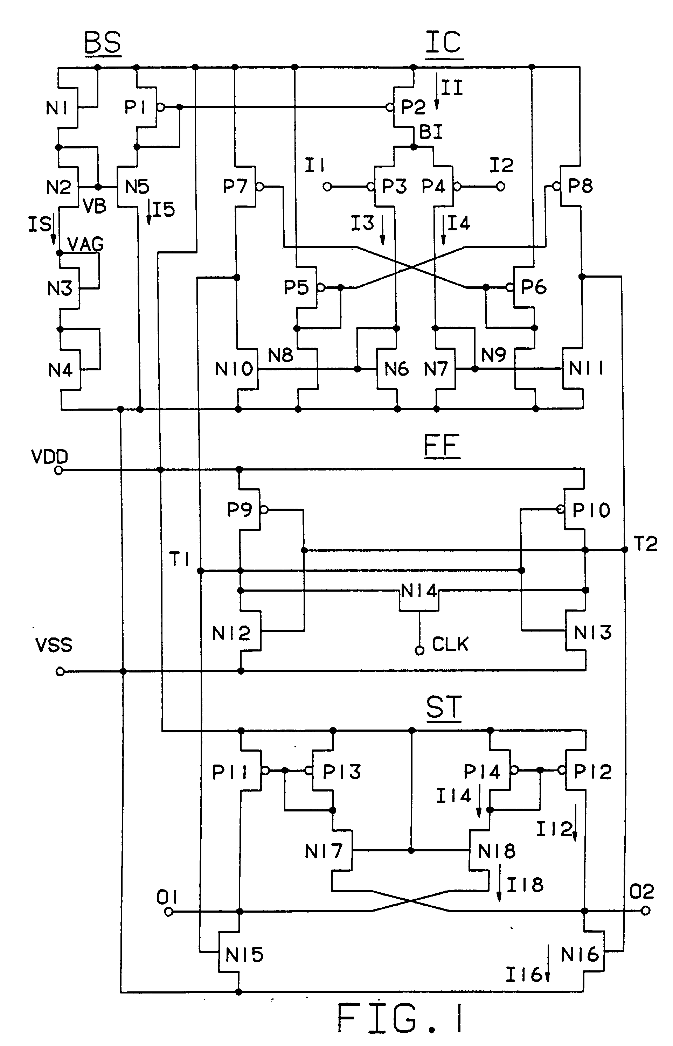

The signal comparator shown in Fig. 1 is a double ended circuit which is for instance used as a one bit analog to digital converter forming part of the last stage of a sigma-delta modulator and able to provide differential Pulse Density Modulated (PDM) output signals. It has differential input terminals I1 and I2 and differential output terminals O1 and O2 providing respectively like named complementary output signals. The comparator is connected to a power supply (not shown) which provides the supply voltages VSS of 0 Volts (ground) and VDD of 5 Volts, and to a clock signal generator CLK supplying a clock signal, e.g. of 15.36 MegaHertz, all these signals being applied to the comparator via respective like named terminals. The comparator comprises four stages all connected to the supply voltages VDD and VSS:

- a current source or bias source BS including NMOS transistors N1 to N5 and PMOS transistors P1 and P2, and having an output terminal BI;
- an input circuit IC including NMOS transistors N6 to N11 and PMOS transistors P3 to P8, whose input terminals I1 and I2 are those of the comparator, which has the input current supply terminal BI connected to the bias source BS, and which has output terminals T1 and T2;
- a bistable device or flipflop circuit FF including NMOS transistors N12, N13 and N14 and PMOS transistors P9 and P10 and to which the clock terminal CLK and the output terminals T1 and T2 of the input device IC are connected; and
- a bistate device or Schmitt trigger ST including NMOS transistors N15 to N18 and PMOS transistors P11 to P14, to which the output terminals T1 and T2 of the input circuit IC are also connected, its output terminals O1 and O2 being those of the comparator.

It is to be noted that the PMOS transistors have generally their source electrode connected to the most positive voltage terminal, e.g. VDD, whilst the NMOS transistors have generally their source electrode connected to the less positive voltage terminal, e.g. VSS. Moreover, a transistor having its gate and drain electrodes interconnected is called hereinafter a diode connected transistor.

The bias source BS includes two parallel branches between the voltage supply terminals VDD and VSS. A first branch includes the diode connected transistors N1 to N4 in series and the second branch includes the series connection of the diode connected transistor P1 and the drain-to-source path of the transistor N5 of which the gate electrode is connected to that of the transistor N2 of the first branch in a current mirror configuration. The gate and the drain electrodes of the transistor P1 are both connected the gate electrode of the transistor P2 feeding the input circuit IC. The transistor P2 has its drain electrode connected to the output terminal BI of the bias source BS and so further to the like named input current supply terminal of the input circuit IC for which this transistor P2 constitutes a constant current source.

The input circuit IC includes six branches coupled between the voltage supply terminals VDD and VSS. The first two of these branches are each constituted by the series connection of the source-to-drain path of the transistor P3/P4 and the diode connected transistor N6/N7. The source electrode of the transistor N6/N7 is connected to the voltage supply terminal VSS whilst the voltage supply terminal VDD is connected to both these two branches via the commonly used current source P2. The input terminals I1 and I2 are connected to the gate electrodes of the transistors P3 and P4 respectively. Two other branches are constituted by the series connection of the diode connected transistor P5/P6 and the drain-to-source path of the transistor N8/N9, and the two last branches are constituted by the series connection of source-to-drain path of the transistor P7/P8 and the drain-to-source path of the transistor N10/N11. The branches P5, N8 and P6, N9 are used in current mirror configuration with the branches P2, P3, N6 and P2, P4, N7 respectively. Both the pairs of transistors P5, N9 and P6, N8 control in a complementary way the pairs of transistors P8, N11 and P7, N10 respectively. The junction points between the drain electrodes of the transistors P7 and N10 and of the transistors P8 and N11 are used as respective input terminals T1 and T2 for the flipflop circuit FF as well as for the Schmitt trigger ST.

The flipflop circuit FF includes between the voltage supply terminals VDD and VSS two parallel branches each comprising the series connection of the source-to-drain path of the transistor P9/P10 and the drain-to-source path of the transistor N12/N13. The terminal T1/T2 is connected to the junction point of the drain electrodes of the transistors P9/P10 and N12/N13 as well as to the interconnected gate electrodes of the transistors P10/P9 and N13/N12 respectively. The terminal T1 is further coupled to the terminal T2 via the source-to-drain path of the transistor N14 of which the gate electrode is controlled by the clock signal CLK applied thereto via the like named clock terminal.

The bistate device or Schmitt trigger ST includes between the voltage supply terminals VDD and VSS two parallel branches each comprising the series connection of the source-to-drain path of the transistor P11/P12 and the drain-to-source path of the transistor N15/N16. The terminal T1/T2 is connected to the gate electrode of the transistor N15/N16 whilst the junction point of the drain electrodes of the transistors P11/P12 and N15/N16 is connected to the output terminal O1/O2. ST further includes between the voltage supply terminal VDD and the output terminal O2 the series connection of the diode connected transistor P13 and the drain-to-source path of the transistor N17, and between this voltage supply terminal VDD and the output terminal O1 the series connection of the diode connected transistor P14 and the drain-to-source path of the transistor N18. The gate electrodes of the transistors N17 and N18 are both connected to the voltage supply terminal VDD whilst the gate and drain electrodes of the transistors P13 and P14 are connected to the gate electrodes of the transistors P11 and P12 respectively in a current mirror configuration.

The purpose of the bias source BS is to maintain a constant current II through the source-to-drain path of the transistor P2 which constitutes the current source of the input circuit IC as already mentioned. The latter IC is a double ended differential amplifier forming the analog input part of the comparator and which receives via its differential input terminals I1 and I2 the analog output signals from the preceding stage of the sigma-delta modulator (not shown). The input circuit IC provides at its differential output terminals T1 and T2 respective analog output signals which are applied to the flipflop circuit circuit FF. According to the relative amplitude of the signals VT1 and VT2 at the respective terminals T1 and T2, the flipflop circuit FF is set in a state which clamps in a complementary way these signals VT1 and VT2 either to the voltage VSS or to the voltage VDD thus providing to the differential input terminals T1 and T2 of the Schmitt trigger ST the logical levels 0 or 1 respectively.

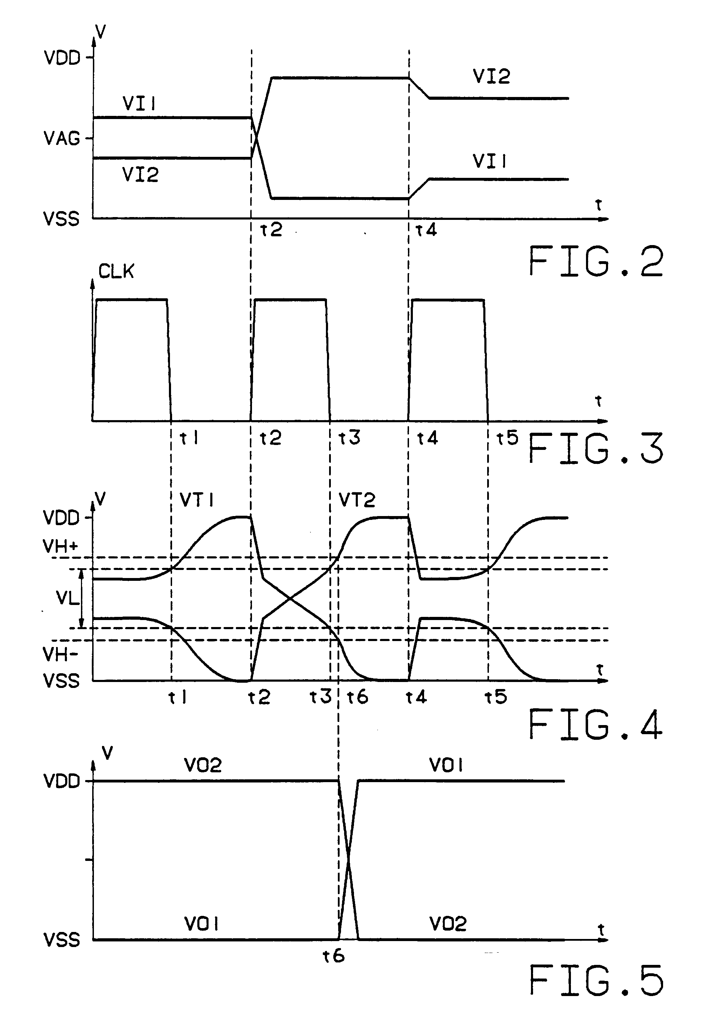

It is to be noted that for each positive value of the clock signal CLK (Fig. 3), the terminals T1 and T2 are almost short-circuited via the transistor N14.

At that moment, unless it is to change following a reversal of the input conditions, the previous state of the flipflop circuit FF is latched owing to the hysteresis function of the Schmitt trigger ST.

The operation of the comparator is explained more in detail hereinafter by making reference to an example illustrated by the waveform signals shown in the Figs. 2 to 5.

First, the bias source BS is described. The purpose of this bias source BS is to provide a current I1 flowing through the source-to-drain path of the transistor P2 which is independent of the threshold voltages VTn and VTp of any NMOS and PMOS transistors respectively forming part of this bias source BS. Since the current I1 is a mirror copy of the current I5 flowing through the diode connected transistor P1 and also through the drain-to-source path of the transistor N5 connected in series therewith, it is necessary to obtain that the current I5 is independent of VTn and VTp.

The current I5 is equal to

$$I5 = (mn*Cox/2) * (W5/L5) * (Vgs5 - VTn)^{**}2 \qquad (1)$$

wherein
| | |
|---|---|
| * | is the multiplication sign for the adjoining terms; |
| ** | precedes the exponent for the previous term; |
| mn | is the mobility of the charge carriers; |
| Cox | is the capacity of the oxide; |
| VTn | is the threshold voltage; |
| W5 | is the width of the channel of the transistor N5; |
| L5 | is the length of the channel of the transistor N5; and |
| Vgs5 | is the gate-to-source voltage of the transistor N5 which is equal to |

$$Vgs5 = VB - VSS \qquad (2)$$

wherein
| | |
|---|---|
| VB | is the bias voltage at the interconnected gate electrodes of the transistors N5 and N2. |

It is to be noted that the parameters mn, Cox and the threshold voltages VTn are almost identical for all the NMOS transistors built on a same chip. The above equation (1) may for instance be found in the book "INTRODUCTION TO VLSI SYSTEMS" by C. MEAD et al published by "ADDISON-WESLEY PUBLISHING COMPANY", chapter 1.1 "MOS Devices and Circuits", page 5.

In this bias source BS, the transistor N1 is chosen identical to the transistor N4 and the transistor N2 is chosen identical to the transistor N3. One may thus write

$$W1/L1 = W4/L4 \qquad (3)$$

and

$$W2/L2 = W3/L3 \qquad (4)$$

wherein
W1, W2, W3 and W4
are the widths of the channels of the transistors N1, N2, N3 and N4 respectively; and
L1, L2, L3 and L4
are the lengths of the channels of the transistors N1, N2, N3 and N4 respectively.

Furthermore, the construction of these transistors is such that

$$W2/L2 = N * (W1/L1) \qquad (5)$$

and thus

$$W3/L3 = N * (W4/L4) \qquad (6)$$

wherein
N is a proportionality factor.

On the one hand, the current I1 flowing through the diode connected transistor N1 is equal to

$$I1 = (mn*Cox/2) * (W1/L1) * (Vgs1 - VTn)^{**}2 \qquad (7)$$

wherein
| | |
|---|---|
| W1 | is the width of the channel of the transistor N1; |
| L1 | is the length of the channel of the transistor N1; and |
| Vgs1 | is the gate-to-source voltage of the transistor N1 which is equal to |

$$Vgs1 = VDD - VB \qquad (8)$$

Thus

$$I1 = (mn*Cox/2) * (W1/L1) * (VDD-VB-VTn)^{**}2 \qquad (9)$$

On the other hand, the current I2 flowing through the diode connected transistor N2 is equal to

$$I2 = (mn*Cox/2) * (W2/L2) * (Vgs2 - VTn)^{**}2 \qquad (10)$$

wherein
| | |
|---|---|
| W2 | is the width of the channel of the transistor N2; |
| L2 | is the length of the channel of the transistor N2; and |
| Vgs2 | is the gate-to-source voltage of the transistor N1 which is equal to |

$$Vgs2 = VB - VAG \qquad (11)$$

wherein

VAG    is the voltage at the junction point between the source electrode of the transistor N2 and the drain and gate electrodes of the transistor N3.

Thus

$$I2 = (mn*Cox/2) * (W2/L2) * (VB-VAG-VTn)**2 \qquad (12)$$

The equation (12) combined with the equation (5) may be written

$$I2 = (mn*Cox/2) *N*(W1/L1)* (VB-VAG-VTn)**2 \qquad (13)$$

Because the four diode connected transistors N1 to N4 are in series a same current IS flows through the drain-to-source paths. Therefore, with I1 and I2 each equal to IS, the equations (9) and (13) then lead to

$$(VDD-VB-VTn)**2 = N * (VB-VAG-VTn)**2 \qquad (14)$$

By choosing the proportionality coefficient N large, this is solved by the physically acceptable approximation

$$VB = VAG + VTn \qquad (15)$$

Which, used in equation (2), causes equation (1) to become

$$I5 = (mn*Cox/2) * (W5/L5) * (VAG - VSS)**2 \qquad (16)$$

This last form shows that the current I5 and thus also the current II which is a mirror copy thereof - with or without a proportionality coefficient - is independent of the threshold voltages VTn and VTp of the transistors of the bias source BS when the coefficient N is chosen sufficiently large. This means that the transistors N2 and N3 are much greater than the transistors N1 and N4.

Fig. 2 shows an example of differential input voltage waveforms VI1 and VI2 respectively applied to the input terminals I1 and I2 of the input circuit IC. Up to the instant t2, the voltage VI1 is more positive than the voltage VI2. At this instant t2, the amplitudes of these voltages VI1 and VI2 are modified so that the voltage VI2 then becomes more positive than the voltage VI1. At the instant t4 on Fig. 2, the amplitudes of these voltages VI1 and VI2 again change but the amplitude of the voltage VI2 remains higher than that of the voltage VI1.

As long as the voltage VI1 is more positive than the voltage VI2, i.e. before t2, the transistor P4 is more conductive than the transistor P3. The current I4 flowing through the transistor P4 is then larger than the current I3 flowing through the transistor P3, although the sum of these currents I4 and I3 remains equal to the current II flowing through the transistor P2. These currents I4 and I3 are mirrored to the other branches of the input circuit IC via the diode connected transistors N7 and N6 respectively. As a result the transistors N9, N11, P6 and P7 are more conductive than the transistors N8, N10, P5, and P8. As shown in Fig. 4, the voltage VT1 at the terminal T1 is then more positive than the voltage VT2 at the terminal T2.

As long as the clock signal CLK shown in Fig. 3 is high, the transistor N14 of the flipflop circuit FF is closed so that the terminals T1 and T2 are then almost short-circuited by this transistor N14. This appears in Fig. 4 where prior to the instant t1 at which the clock signal CLK becomes low, the voltages VT1 and VT2 are forced within a voltage range VL located near the average voltage VAG of 2.5 Volts. However, due to the voltage VT1 being more positive than the voltage VT2, the transistors N13 and P9 of the flipflop circuit FF are more conductive than the transistors N12 and P10 thereof. This anticipates the next coming state of this flipflop circuit FF which will be effective when the clock signal CLK is low, i.e. between the instants t1 and t2 in Fig. 3. From this instant t1, the transistor N14 becomes blocked so that the flipflop circuit FF may bring the terminals T1 and T2 to the respective voltages VDD (5 Volts) and VSS (0 Volts), i.e. to the logical levels 1 and 0 respectively. The variation of these voltages VT1 and VT2 to these logical levels occurs slowly because until the instant t2 the relative amplitudes of the input voltages VI1 and VI2 are low with respect to that of the average voltage VAG and that the flipflop circuit FF has to overwin these input voltages VI1 and VI2 and lead them to the extreme values of VDD and VSS respectively.

At t2, the clock signal CLK is again high as a consequence of which the amplitudes of the voltages VT1 and VT2 are brought within the voltage range VL. Because after t2, the amplitude of the input voltage VI1 becomes lower than that of the voltage VI2, the flipflop circuit FF has to change its state. This occurs while the clock signal is high, i.e. between t2 and t3. When the clock signal CLK becomes low at the instant t3, the amplitude of the voltages VT1 and VT2 are already inverted but both remain within the voltage range VL. From the instant t3, the amplitude of the voltages VT1 and VT2 rapidly reach their respective final amplitudes or logical levels 0 and 1. This variation occurs faster than that previously described because the difference of the input voltages VI1-VI2 is now greater (Fig. 2), i.e. closer to the difference of the supply voltages VDD-VSS.

At the instant t4, when the clock signal CLK becomes high, the amplitudes of the voltages VT1 and VT2 are again brought within the voltage range VL but because the input voltage VI2 now remains more positive than the input voltage VI1, the same is true for the respective voltages VT2 and VT1. When the clock signal CLK becomes low at the instant t5, the voltages VT1 and VT2 return to their respective previous logical levels, i.e. to the logical level they had before t4. Since the relative amplitudes of the input voltages VI1 and VI2 with respect to that of the average voltage VAG are now relatively lower than these before t4 (fig. 2), the voltages VT1 and VT2 vary a little slower.

The purpose of bringing the two voltages VT1 and VT2 back to a neutral value, i.e. within the voltage range VL, at each high clock signal CLK is to reduce the transition time when the flipflop circuit FF changes state. Indeed, when for instance the input voltage VI1 was more positive than the input voltage VI2 and that this situation is changed, at the following occurence of a low clock signal CLK the voltages VT1 and VT2 have then only to vary by 2.5 Volts (VDD-VAG or VAG-VSS) instead of 5 Volts (VDD-VSS).

The voltage range VL is so chosen that it is within the hysteresis voltage range from VH- to VH+ (Fig. 4) of the Schmitt trigger ST. In this way, the Schmitt trigger ST remains in its previous state as long as the amplitude of the voltage VT1 or VT2 which was the less positive does not exceed the upper value of the hysteresis voltage range VH+. Then, the output voltages VO1 and VO2 at the output terminals O1 and O2 switch from the logical levels 0 to 1 and vice versa. In the present example, such a variation only occurs at the instant t2 and the state of the Schmitt trigger ST shown in Fig. 5 only changes at the instant t6 - after t3 - when the amplitude of the voltage VT2 increases up to the upper hysteresis voltage VH+ and the amplitude of the voltage VT1 becomes lower than the hysteresis voltage VH-.

More in detail, when the amplitude of the voltage VT1 is relatively larger than that of the voltage VT2 and it exceeds the hysteresis voltage VH+, the transistors N15 and P12 are more conductive than the transistors N16 and P11. As a result, the voltage VO1 at the terminal O1 is at the logical level 0, and the voltage VO2 at the terminal O2 is at the logical level 1. In other words, the voltage VO2 at the output terminal O2 is at the logical level 1 when the current I12 flowing through the source-to-drain path of the transistor P12 is greater than the current I16 flowing through the drain-to-source path of the transistor N16. The switching of the Schmitt trigger ST occurs when the current I12 is equal to the current I16. It is obvious that by symmetry the same reasoning may be made for the currents flowing through the transistors P11 and N15.

The present Schmitt trigger ST is so built that this transition point, i.e. when the current I12 becomes equal to the current I16, is known with accuracy and is independent of the construction or process parameters of the constituent transistors. Indeed, by construction

$$W12/L12 = A * (W14/L14) \qquad (17)$$

$$W16/L16 = B * (W18/L18) \qquad (18)$$

wherein
  A and B
  are proportionality coefficients both greater than 1;
  W12, W14, W16 and W18
  are the widths of the channels of the transistors P12, P14, N16 and N8 respectively; and
  L12, L14, L16 and L18
  are the lengths of the channels of the transistors P12, P14, N16 and N8 respectively.

The current I12 is controlled by the transistor N18 of which the drain-to-source current I18 is mirrored to the transistor P12 via the diode connected transistor P14. The gate-to-source voltage Vgs18 of the transistor N18 is equal to

$$Vgs18 = VDD - VO1 \qquad (19)$$

and its drain-to-source current I18 is thus equal to

$$I18 = (mn*Cox/2)*(W18/L18)*(VDD-VO1-VTn)^{**2} \qquad (20)$$

Since the transistors N18 and P14 are in series, the drain-to-source current I14 of the transistor P14 is equal to the current I18, and because of the relation (17) one may write

$$I12 = I14 * A = I18 * A \qquad (21)$$

$$I12 = (mn*Cox/2)*(W18/L18)* A *(VDD-VO1-VTn)^{**2} \qquad (22)$$

or, combined with the relation (18) to have I12 in function of W16 and L16

$$I12 = (mn*Cox/2)*(W16/L16)*A/B*(VDD-VO1-VTn)^{**2} \qquad (23)$$

On the other hand, the gate-to-source voltage Vgs16 of the transistor N16 is equal to

$$Vgs16 = VT2 - VSS \quad (24)$$

and its drain-to-source current I16 is equal to

$$I16 = (mn*Cox/2)*(W16/L16)*(VT2-VSS-VTn)^{**}2 \quad (25)$$

It is to be noted that the current I16 increases with the voltage VT2.

From the equations (23) and (25), it appears that at the transition point of the Schmitt trigger ST these currents I12 and I16 are both independent of the parameters mp and of the threshold voltage VTp of any PROS transistor, more especially of the transistor P12. Furthermore, by equating the currents I12 and I16, this transition point is also shown to be independent of the parameter mn of any NMOS transistor and of the parameter Cox. Finally, by a suitable choice of the proportionality coefficients A and B, the equations (23) and (25) may become, in a first approximation, almost independent of the threshold voltage VTn of any NMOS transistor. Indeed, these coefficients may be so chosen that any variation of the threshold voltage VTn affects almost in a same way the values of both the currents I12 and I16 so that such a variation is compensated.

Because the operational characteristics of this Schmitt trigger ST are substantially independent of the process parameters of the constituent transistors thereof, identical circuits can be produced on a large scale.

## Claims

1. Bistate device (ST) including two parallel branches (P11, N15; P12, N16) each comprising the series connection of a first transistor (P11; P12) of a first conductivity type (P) and a second transistor (N15; N16) of a second conductivity type (N), the current in said first transistor of each branch being controlled from the junction point (O2; O1) of the first and second transistors of the opposite branch, and a diode-connected third transistor (P13; P14) which is of said first conductivity type (P) being connected between the control electrode of said first transistor and a reference voltage terminal (VDD), characterized in that each of said control electrodes of said first transistors (P11; P12) is coupled to said junction point (O2; O1) through a fourth transistor (N17; N18) of said second conductivity type (N) whose control electrode is connected to said reference voltage terminal (VDD), the series connection of the third (P13; P14) and fourth (N17; N18) transistor forming a current control device (P13, N17; P14, N18).

2. Bistate device (ST) according to claim 1, characterized in that said first (P11; P12) and third (P13; P14) transistors are PMOS transistors, whilst said second (N15; N16) and fourth (N17; N18) transistors are NMOS transistors, that said control electrode is the gate electrode of said fourth transistor (N17; N18), and that said two parallel branches (P11, N15; P12, N16) are connected between a first (VDD) and a second (VSS) voltage supply terminals of a DC source, said first voltage supply terminal (VDD) being at a more positive voltage than said second voltage supply terminal (VSS).

3. Bistate device (ST) according to claim 2, characterized in that said reference voltage terminal (VDD) is said first voltage supply terminal (VDD).

4. Bistate device (ST) according to claim 2, characterized in that each of said current control device (P13, N17; P14, N18) is connected between said first voltage supply terminal (VDD) and the corresponding junction point (O2; O1).

5. Bistate device (ST) according to the claims 3 and 4, characterized in that, in each of said current control devices (P13; N17; P14; N18), both the gate and drain electrodes of the third transistor (P13; P14) are connected to the gate electrode of the first transistor (P11; P12) of one of said branches (P11, N15; P12, N16) whilst the source electrode of the fourth transistor (N17; N18) is connected to said junction point (O2; O1) of the opposite branch, said first voltage supply terminal (VDD) being connected to the gate electrodes of both said fourth transistors (N17; N18).

6. Bistate device (ST) according to claim 1, characterized in that it has differential input terminals (T1; T2) each connected to the control terminal of a respective one of said second transistors (N15; N16) and differential output terminals (O1; O2) to which respective ones of said junction points (O1; O2) are connected.

## Patentansprüche

1. Zwei-Zustands-Anordnung (ST) mit zwei parallelen Zweigen (P11, N15; P12, N16), von denen jeder die Serienschaltung eines ersten Transistors (P11; P12) eines ersten Leitfähigkeitstyps (P) und eines zweiten Transistors (N15; N16) eines zweiten Leitfähigkeitstyps (N) enthält, bei der der Strom in dem ersten Transistor jedes Zweigs vom Verbindungspunkt (O2; O1) des ersten und zweiten Transistors des gegenüberliegenden Zweigs aus gesteuert wird und bei der ein als Diode geschalteter dritter Transistor (P13; P14) des ersten Leitfähigkeitstyps (P) zwischen die Steuerelektrode des ersten Transistors und einen Bezugsspannungs-Anschluß (VDD) geschaltet ist, **dadurch gekennzeichnet**, daß jede der Steuerelektroden der ersten Transistoren (P11; P12) durch einen vierten Transistor (N17; N18) des zweiten Leitfähigkeitstyps (N), dessen Steuerelektrode mit dem Bezugspannungs-Anschluß (VDD) verbunden ist, an den genannten Verbindungspunkt (O2, O1) angekoppelt ist, so daß die Reihenschaltung des dritten (P13; P14) und vierten (N17; N18) Transistors eine Strom-Steuerungsschaltung (P13, N17; P14, N18) bildet.

2. Zwei-Zustands-Anordnung (ST) nach Anspruch 1, dadurch gekennzeichnet, daß die ersten (P11; P12) und dritten (P13; P14) Transistoren PMOS-Transistoren sind, wogegen die zweiten (N15; N16) und vierten (N17; N18) Transistoren NMOS-Transistoren sind, daß die Steuerelektrode die Gate-Elektrode des vierten Transistors (N17; N18) ist und daß die zwei parallelen Zweige (P11, N15; P12, N16) zwischen einen ersten (VDD) und einen zweiten (VSS) Versorgungsspannungs-Anschluß einer Gleichspannungsquelle geschaltet sind, wobei der erste Versorgungsspannungs-Anschluß (VDD) eine positivere Spannung als der zweite Versorgungsspannungs-Anschluß (VSS) hat.

3. Zwei-Zustands-Anordnung (ST) nach Anspruch 2, dadurch gekennzeichnet, daß der Bezugsspannungs-Anschluß (VDD) der erste Versorgungsspannungs-Anschluß (VDD) ist.

4. Zwei-Zustands-Anordnung (ST) nach Anspruch 2, dadurch gekennzeichnet, daß jede der Stromsteuerungs-Anordnungen (P13, N17; P14, N18) zwischen den ersten Versorgungsspannungs-Anschluß (VDD) und den entsprechenden Verbindungspunkt (O2; O1) geschaltet ist.

5. Zwei-Zustands-Anordnung (ST) nach den Ansprüchen 3 und 4, dadurch gekennzeichnet, daß in jedem der Stromsteuerungs-Anordnungen (P13, N17; P14, N18) sowohl die Gateals auch die Drain-Elektrode des dritten Transistors mit der Gate-Elektrode des ersten Transistors (P11; P12) eines der Zweige (P11, N15; P12, N16) verbunden ist, wogegen die Source-Elektrode des vierten Transistors (N17; N18) mit dem Verbindungspunkt (O2; O1) des gegenüberliegenden Zweigs verbunden ist und daß der erste Versorgungsspannungs-Anschluß (VDD) mit den Gate-Elektroden der beiden vierten Transistoren (N17; N18) verbunden ist.

6. Zwei-Zustands-Anordnung (ST) nach Anspruch 1, dadurch gekennzeichnet, daß sie Differenzeingangs-Anschlüsse (T1; T2) hat, von denen jeder mit dem Steueranschluß jeweils eines der zweiten Transistoren (N15; N16) verbunden ist, und Differenzausgangs-Anschlüsse (O1; O2), mit denen die jeweiligen genannten Verbindungspunkte (O1; O2) verbunden sind.

**Revendications**

1. Dispositif à deux états (ST) comprenant deux branches parallèles (P11, N15; P12, N16), chacune constituée de la connexion en série d'un premier transistor (P11; P12) ayant un premier type de conductivité (P) et d'un deuxième transistor (N15; N16) ayant un second type de conductivité (N), le courant dans ledit premier transistor de chaque branche étant contrôlé à partir du point de jonction (O2; O1) des premier et deuxième transistors de la branche opposée, un troisième transistor (P13; P14) connecté en diode et ayant ledit premier type de conductivité (P) étant connecté entre l'électrode de commande du dit premier transistor et une borne de tension de référence (VDD), caractérisé en ce que chacune des dites électrodes de commande des dits premiers transistors (P11; P12) est reliée audit point de jonction (O2; O1) à travers un quatrième transistor (N17; N18) ayant ledit second type de conductivité (N) et dont l'électrode de commande est raccordée à ladite borne de tension de référence (VDD), la connexion en série du troisième (P13; P14) et quatrième (N17; N18) transistors formant un dispositif de contrôle de courant (P13, N17; P14, N18).

2. Dispositif à deux états (ST) selon la revendication 1, caractérisé en ce que les dits premiers (P11; P12) et troisièmes (P13; P14) transistors sont des transistors PMOS, alors que les dits deuxièmes (N15; N16) et quatrièmes (N17; N18) transistors sont des transistors NMOS, en ce que ladite électrode de commande est la grille du dit quatrième transistor (N17; N18), et en ce que les dites deux branches parallèles (P11, N15; P12, N16) sont connectées entre une première (VDD) et une seconde (VSS) bornes de tension d'alimentation d'une source de courant continu, ladite première borne de tension d'alimentation (VDD) étant à un potentiel plus positif que ladite seconde borne de tension d'alimentation (VSS).

3.  Dispositif à deux états (ST) selon la revendication 2, caractérisé en ce que ladite borne de tension de référence (VDD) est ladite première borne de tension d'alimentation (VDD).

4.  Dispositif à deux états (ST) selon la revendication 2, caractérisé en ce que chaque dit dispositif de contrôle de courant (P13, N17; P14, N18) est connecté entre ladite première borne de tension d'alimentation (VDD) et le point de jonction correspondant (O2; O1).

5.  Dispositif à deux états (ST) selon les revendications 3 et 4, caractérisé en ce que, dans chaque dit dispositif de contrôle de courant (P13, N17; P14, N18), la grille et le drain du troisième transistor (P13; P14) sont tous deux raccordés à la grille du premier transistor (P11; P12) d'une des dites branches (P11, N15; P12, N16), alors que la source du quatrième transistor (N17; N18) est raccordée audit point de jonction (O2; O1) de la branche opposée, ladite première borne de tension d'alimentation (VDD) étant raccordée aux grilles des deux dits quatrièmes transistors (N17; N18).

6.  Dispositif à deux états (ST) selon la revendication 1, caractérisé en ce qu'il possède des bornes d'entrées différentielles (T1; T2) chacune raccordée à la borne de commande d'un des dits deuxièmes transistors (N15; N16) respectifs, et des bornes de sorties différentielles (O1; O2) auxquelles un des dits points de jonction (O1; O2) respectifs est raccordé.

FIG. 1

FIG.2

FIG.3

FIG.4

FIG.5